(19) **Europäisches Patentamt / European Patent Office / Office européen des brevets**

(11)  **EP 3 420 412 B1**

(12)  **FASCICULE DE BREVET EUROPEEN**

(45) Date de publication et mention de la délivrance du brevet:
**09.10.2019  Bulletin 2019/41**

(21) Numéro de dépôt: **17705431.9**

(22) Date de dépôt: **20.02.2017**

(51) Int Cl.:
*G03F 7/20* (2006.01)    *B82Y 40/00* (2011.01)
*G03F 7/09* (2006.01)    *G03F 7/11* (2006.01)
*H01J 37/317* (2006.01)    *H01L 21/027* (2006.01)
*H01L 21/311* (2006.01)

(86) Numéro de dépôt international:
**PCT/EP2017/053749**

(87) Numéro de publication internationale:
**WO 2017/144398 (31.08.2017 Gazette 2017/35)**

(54) **PROCEDE DE LITHOGRAPHIE ELECTRONIQUE AVEC ECRANTAGE ELECTROSTATIQUE**

VERFAHREN ZUR ELEKTRONISCHEN LITHOGRAPHIE MIT ELEKTROSTATISCHER ABSCHIRMUNG

METHOD FOR ELECTRONIC LITHOGRAPHY WITH ELECTROSTATIC SCREENING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **25.02.2016  FR 1651541**

(43) Date de publication de la demande:
**02.01.2019  Bulletin 2019/01**

(73) Titulaire: **Commissariat à l'Énergie Atomique et aux Énergies Alternatives
75015 Paris (FR)**

(72) Inventeurs:
• **LATTARD, Ludovic
  38500 Coublevie (FR)**
• **QUEMERE, Patrick
  38340 Voreppe (FR)**

(74) Mandataire: **Priori, Enrico
  Marks & Clerk France
  Immeuble "Visium"
  22, avenue Aristide Briand
  94117 Arcueil Cedex (FR)**

(56) Documents cités:
EP-A2- 0 276 717    FR-A1- 2 994 489
FR-A1- 3 000 234    JP-A- 2004 119 414
US-B1- 6 319 636

• KAZUHIRO SHIMIZU ET AL: "NANOMETER PATTERNING BY ELECTRON BEAM LITHOGRAPHY USING AN AMORPHOUS CARBON FILM AS AN INTERMEDIATE LAYER", JAPANESE JOURNAL OF APPLIED PHYSICS, JAPAN SOCIETY OF APPLIED PHYSICS, JP, vol. 30, no. 4 PART 01, 1 avril 1991 (1991-04-01), pages 890-891, XP000263007, ISSN: 0021-4922, DOI: 10.1143/JJAP.30.890
• CASTOLDI A ET AL: "A new silicon drift detector with reduced lateral diffusion", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 377, no. 2, 1 août 1996 (1996-08-01), pages 375-380, XP004008281, ISSN: 0168-9002, DOI: 10.1016/0168-9002(96)00019-8

**Description**

L'invention porte sur un procédé de lithographie électronique, et plus particulièrement de lithographie électronique à faible énergie.

La lithographie électronique (ou « lithographie par faisceau d'électrons ») est un procédé de micro- et nano-fabrication qui consiste à déposer une résine sensible (« resist ») au-dessus de la surface d'un substrat, à exposer la résine à un faisceau d'électrons de manière à provoquer en son sein des modifications physiques et chimiques localisées, puis à développer la résine, c'est-à-dire enlever sélectivement ses portions exposées (on parle alors de résine « positive ») ou non exposées (résine « négative ») pour mettre à nu les régions sous-jacentes du substrat. Un motif géométrique est donc transféré à la résine par le faisceau d'électrons ; il peut ultérieurement être transféré au substrat à travers les ouvertures pratiquées à travers la couche de résine.

Par rapport à la photolithographie, la lithographie électronique permet d'atteindre des résolutions plus élevées, car les effets de diffraction sont beaucoup moins importants. En fait, en lithographie électronique la résolution est principalement limitée par la diffusion des électrons dans la résine et leur rétrodiffusion par le substrat. La fonction d'étalement du point PSF (de l'anglais « Point Spread Function ») permet de quantifier ces effets ; elle est typiquement exprimée par l'équation suivante :

$$PSF(r) = \frac{1}{\pi(1+\eta)}\left\{\frac{1}{\alpha^2}\cdot e^{-r^2/\alpha^2} + \frac{\eta}{\beta^2}\cdot e^{-r^2/\beta^2}\right\}$$

où :

- r est la distance radiale par rapport au point d'impact du faisceau d'électrons ;
- $\alpha$ est l'écart type de la distribution (supposée gaussienne) des électrons diffusés vers l'avant;
- $\beta$ est l'écart type de la distribution (supposée gaussienne) des électrons rétrodiffusés par le substrat ;
- $\eta$ est la proportion d'électrons rétrodiffusés.

On peut avoir, par exemple, $\alpha$=17 nm, $\beta$=288,3 nm et $\eta$=0,35.

Pour minimiser l'étalement de la PSF, on utilise généralement des faisceaux d'électrons d'énergie comprise entre 50 keV et 100 keV. Cependant, l'utilisation d'énergies aussi élevées provoque un réchauffement, et donc une déformation thermique, du substrat. Cela nuit à la précision du transfert du motif géométrique. Pour éviter cet effet, il a été proposé d'utiliser des électrons de faible énergie - typiquement 5 à 10 keV - présentant néanmoins une profondeur de pénétration suffisante (de l'ordre de 300 nm). Dans ces conditions, cependant, la diffusion des électrons est importante, ce qui limite la résolution spatiale atteignable.

Il a également été proposé, afin de réduire l'étalement de la PSF, d'insérer une couche intermédiaire de faible densité atomique entre la résine et le substrat, voir par exemple le document FR 2 994 489.

L'invention vise à remédier aux inconvénients précités de l'art antérieur. Plus particulièrement elle vise à améliorer la résolution spatiale de la lithographie électronique, et notamment de la lithographie électronique à faible énergie.

Conformément à l'invention, ce but est atteint grâce à l'implantation préalable d'électrons dans le substrat - ou dans une couche diélectrique déposée à sa surface. Ces électrons sont distribués spatialement de manière à générer un champ électrique répulsif qui s'oppose à la diffusion des électrons utilisés pour l'étape de lithographie proprement dite.

Un objet de l'invention est donc un procédé de lithographie électronique comprenant les étapes suivantes :

- implanter dans un substrat, ou dans une couche diélectrique sacrificielle déposée à la surface dudit substrat, des électrons suivant un premier motif ;
- déposer une résine pour lithographie électronique à la surface dudit substrat ou de ladite couche diélectrique sacrificielle ; et
- exposer ladite résine au moyen d'un faisceau d'électrons suivant un second motif, puis la développer ;

lesdits premier et second motifs étant constitués par des motifs élémentaires, les motifs élémentaires dudit premier motif entourant au moins partiellement les motifs élémentaires dudit second motif.

D'autres caractéristiques, détails et avantages de l'invention ressortiront à la lecture de la description faite en référence aux dessins annexés donnés à titre d'exemple et qui représentent, respectivement :

- Les figures 1A à 1F, six étapes d'un procédé selon un mode de réalisation de l'invention ;
- La figure 2, un exemple de motif géométrique de lithographie, et du motif d'implantation électronique préalable qui lui est associé ; et

- La figure 3 illustre le champ électrique obtenu grâce à l'implantation électronique préalable à la lithographie.

Les figures ne sont pas à l'échelle.

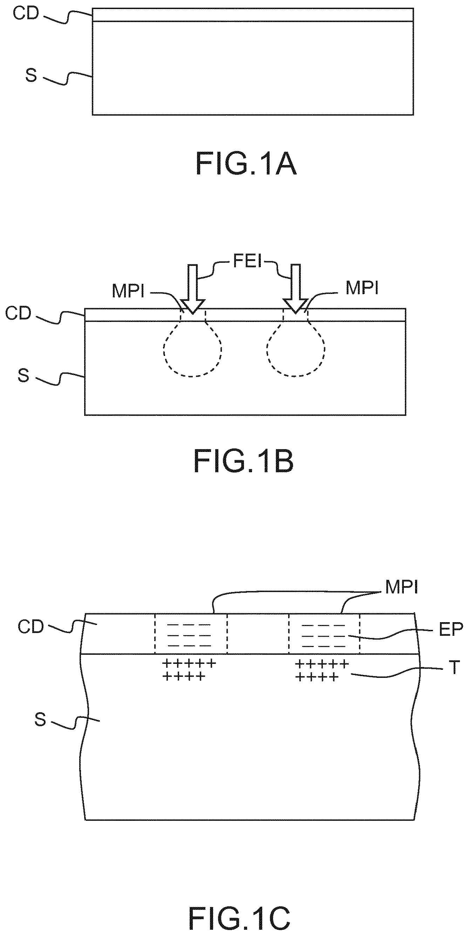

La figure 1A montre un substrat semi-conducteur S, par exemple en silicium, sur lequel est déposée une couche sacrificielle (c'est-à-dire destinée à être enlevée) CD en matériau diélectrique - par exemple en oxyde de silicium, oxyde métallique, nitrure de titane, etc. L'épaisseur de cette couche CD est typiquement de l'ordre de quelques dizaines de nanomètres, par exemple comprise entre 10 et 100 nm et de préférence entre 20 et 50 nm. Sa résistivité est de préférence supérieure ou égale à $10^6$ $\Omega/\blacksquare$ (Ohms/carré). Si le substrat est isolant, la couche CD peut être absente.

Une implantation d'électrons est réalisée dans la couche CD au moyen d'un faisceau électroniques FEI, suivant un motif géométrique élémentaires MPI dont les caractéristiques seront discutées plus loin. Cette étape est illustrée sur la figure 1B ; dans ce mode de réalisation particulier, le motif élémentaire MPI est en forme d'anneau. Une fraction des électrons du faisceau FEI sont piégés dans le diélectrique, les autres diffusent dans le substrat semi-conducteur, qui est relié à la masse. Les nuages de diffusion des électrons sont représentés en trait pointillé sur la figure. La dose d'implantation dans la couche CD, définie comme la densité de charge incidente, est généralement comprise entre 1 et 100 $\mu C/cm^2$ ; de préférence elle est déposée à très basse énergie (moins de 5 keV) pour maximiser le taux d'électrons qui restent piégés dans le diélectrique. La figure 1C représente schématiquement les électrons EP piégés dans la couche diélectrique CD ; on peut y voir que le motif d'implantation MPI a été transféré à la couche diélectrique sous la forme d'une densité de charge négative. On peut également noter qu'il se produit dans le substrat, à proximité de l'interface avec la couche diélectrique, une accumulation de trous T, attirés par les électrons piégés ED.

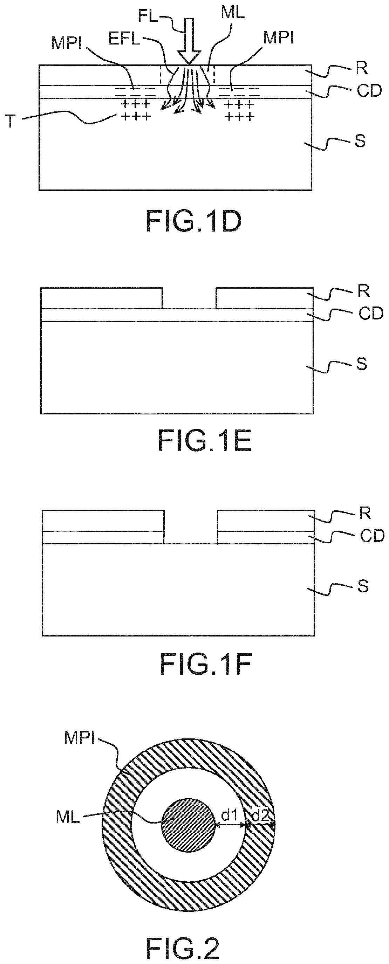

Ensuite, comme illustré sur la figure 1D, une couche de résine R est déposée sur la couche diélectrique CD, puis cette résine est exposée à un faisceau d'électrons FL, de préférence à faible énergie (10 keV ou moins, voire 5 keV ou moins) selon un motif géométrique élémentaire de lithographie ML. Dans l'exemple de la figure, le motif élémentaire ML a la forme d'un disque circulaire, situé à l'intérieur du motif d'implantation préalable MPI, en anneau ; ces deux motifs sont illustrés sur la figure 2. Plus généralement, le motif élémentaire d'implantation préalable MPI entoure le motif de lithographie. Si ce dernier a la forme d'une piste linéaire, par exemple, le motif MPI sera constitué par deux autres pistes linéaires, situées de part et d'autre de la première.

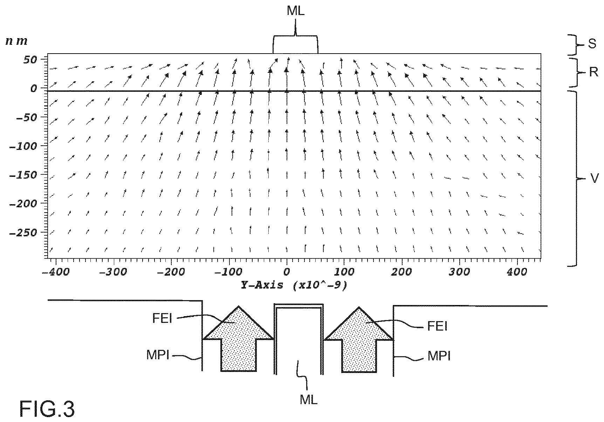

On peut voir sur la figure 1D que les électrons EFL du faisceau de lithographie FL sont repoussés par les électrons EP piégés dans la couche CD, ce qui a l'effet de les confiner à l'intérieur du motif de lithographie ML, limitant leur diffusion. La figure 3 montre le champ électrostatique dans le vide V, au dessus de la couche de résine R. On peut remarquer que le champ électrostatique converge vers le centre du motif ML.

Après avoir traversé la couche, les électrons EFL parviennent au substrat, où ils se recombinent rapidement avec les trous T accumulés à l'interface substrat - couche diélectrique. Cette recombinaison rapide réduit la fraction d'électrons rétrodiffusés $\eta$ et contribue donc à limiter l'étalement de la PSF. Cet effet ne se produit pas si le substrat est isolant.

La dose de charge implantée et la géométrie du motif d'implantation MPI peuvent être optimisés au moyen de simulations numériques tenant compte de la diffusion des électrons EFL dans la résine et dans le substrat, ainsi que de l'influence du champ électrique généré par les électrons piégés EP et les trous T. Dans le cas d'un motif élémentaire de lithographie ML en forme de disque et d'un motif d'implantation MPI en forme de couronne circulaire, il n'y a que trois paramètres à optimiser : la dose implantée, l'espacement entre le motif ML et le motif MPI (représenté par d1 sur la figure 2) et la largeur de la couronne circulaire MPI (d2). On peut donc procéder aisément par essais.

Les étapes ultérieures du procédé sont conventionnelles : on développe la résine exposée, de manière à obtenir une ouverture en correspondance du motif de lithographie ML - si la résine est positive - ou de son complément - si la résine est négative (figure 1E) puis, ou en même temps, on grave la couche diélectrique sacrificielle CD (figure 1F) de manière à mettre à nu le substrat S. On peut ensuite procéder, par exemple, au dépôt d'une métallisation à la surface du substrat, en correspondance de l'ouverture ainsi obtenue (non représenté).

Bien entendu, dans les applications réelles le motif d'implantation et le motif de lithographie seront constitués par un grand nombre de motifs élémentaires tels que ceux représentés sur les figures.

## Revendications

1. Procédé de lithographie électronique comprenant les étapes suivantes :

   - implanter dans un substrat (S), ou dans une couche diélectrique sacrificielle (CD) déposée à la surface dudit substrat, des électrons suivant un premier motif ;
   - déposer une résine (R) pour lithographie électronique à la surface dudit substrat ou de ladite couche diélectrique sacrificielle ; et

- exposer ladite résine au moyen d'un faisceau d'électrons (FL) suivant un second motif, puis la développer ;

lesdits premier et second motifs étant constitués par des motifs élémentaires, les motifs élémentaires dudit premier motif (MPI) entourant au moins partiellement les motifs élémentaires dudit second motif (ML).

**2.** Procédé selon la revendication 1 comprenant également une étape préalable de dépôt de ladite couche diélectrique (CD) à la surface dudit substrat (S), et une étape de gravure des régions de ladite couche diélectrique exposées suite au développement de la résine (R).

**3.** Procédé selon la revendication 2 dans lequel ladite couche diélectrique (CD) présente une épaisseur comprise entre 10 et 100 nm et de préférence entre 20 et 50 nm.

**4.** Procédé selon l'une des revendications 2 ou 3 dans lequel ladite couche diélectrique (CD) présente une résistivité supérieure ou égale à $10^6$ $\Omega/\blacksquare$.

**5.** Procédé selon l'une des revendications 2 à 4 dans lequel ledit substrat (S) est un substrat semi-conducteur.

**6.** Procédé selon l'une des revendications précédentes dans lequel ladite résine (R) est exposée au moyen d'un faisceau d'électrons (FL) d'énergie inférieure ou égale à 10 keV et de préférence à 5 keV.

**7.** Procédé selon l'une des revendications précédentes comportant l'implantation d'une densité de charge comprise entre 1 et 100 $\mu$C/cm$^2$ dans ledit substrat ou ladite couche diélectrique.

**8.** Procédé selon l'une des revendications précédentes comportant une étape préalable d'optimisation dudit premier motif pour que le champ électrique généré par les électrons implantés concentre le faisceau d'électrons utilisé pour exposer la résine à l'intérieur des motifs élémentaires dudit second motif.

**Patentansprüche**

**1.** Elektronisches Lithographieverfahren, das die folgenden Schritte beinhaltet:

- Implantieren von Elektronen gemäß einem ersten Muster in ein Substrat (S) oder in eine auf der Oberfläche des Substrats abgesetzte dielektrische Opferschicht (CD);
- Absetzen eines Harzes (R) für elektronische Lithographie auf die Oberfläche des Substrats oder der elektrischen Opferschicht; und
- Exponieren des Harzes mit einem Elektronenstrahl (FL) gemäß einem zweiten Muster, dann Entwickeln desselben;

wobei das erste und das zweite Muster von Elementarmustern gebildet werden, wobei die Elementarmuster des ersten Musters (MPI) die Elementarmuster des zweiten Musters (ML) wenigstens teilweise umgeben.

**2.** Verfahren nach Anspruch 1, das auch einen Vorabschritt des Absetzens der dielektrischen Schicht (CD) auf die Oberfläche des Substrats (S) und einen Schritt des Ätzens von Regionen der dielektrischen Schicht beinhaltet, die nach der Entwicklung des Harzes (R) freigelegt werden.

**3.** Verfahren nach Anspruch 2, bei dem die dielektrische Schicht (CD) eine Dicke zwischen 10 und 100 nm und vorzugsweise zwischen 20 und 50 nm aufweist.

**4.** Verfahren nach Anspruch 2 oder 3, bei dem die dielektrische Schicht (CD) eine Resistivität von gleich oder größer als $10^6$ $\Omega/cm^2$ hat.

**5.** Verfahren nach einem der Ansprüche 2 bis 4, bei dem das Substrat (S) ein Halbleitersubstrat ist.

**6.** Verfahren nach einem der vorherigen Ansprüche, bei dem das Harz (R) mittels eines Elektronenstrahls (FL) mit einer Energie gleich oder kleiner als 10 keV und vorzugsweise als 5 keV exponiert wird.

**7.** Verfahren nach einem der vorherigen Ansprüche, das das Implantieren einer Ladungsdichte zwischen 1 und 100

$\mu$C/cm$^2$ in dem Substrat oder der dielektrischen Schicht beinhaltet.

8. Verfahren nach einem der vorherigen Ansprüche, das einen Vorabschritt des Optimierens des ersten Musters beinhaltet, damit das von den implantierten Elektronen erzeugte elektrische Feld den zum Exponieren des Harzes benutzten Elektronenstrahl im Inneren der Elementarmuster des zweiten Musters konzentriert.

**Claims**

1. An electronic lithography process comprising the following steps:

   - implanting into a substrate (S), or into a sacrificial dielectric layer (CD) deposited on the surface of said substrate, electrons in a first pattern;
   - depositing an electronic lithography resist (R) on the surface of said substrate or of said sacrificial dielectric layer; and
   - exposing said resist by means of an electron beam (FL) in a second pattern, then developing said resist;

   said first and second patterns being made up of elementary patterns, the elementary patterns of said first pattern (MPI) at least partially surrounding the elementary patterns of said second pattern (ML).

2. The process as claimed in claim 1, also comprising a prior step of depositing said dielectric layer (CD) on the surface of said substrate (S), and a step of etching the regions of said dielectric layer that are exposed following the development of the resist (R).

3. The process as claimed in claim 2, wherein said dielectric layer (CD) has a thickness comprised between 10 and 100 nm and preferably between 20 and 50 nm.

4. The process as claimed in either of claims 2 and 3, wherein said dielectric layer (CD) has a resistivity higher than or equal to $10^6$ $\Omega$/cm$^2$.

5. The process as claimed in one of claims 2 to 4, wherein said substrate (S) is a semiconductor substrate.

6. The process as claimed in one of the preceding claims, wherein said resist (R) is exposed by means of an electron beam (FL) of energy lower than or equal to 10 keV and preferably 5 keV.

7. The process as claimed in one of the preceding claims, including implanting a charge density comprised between 1 and 100 $\mu$C/cm$^2$ into said substrate or said dielectric layer.

8. The process as claimed in one of the preceding claims, including a prior step of optimizing said first pattern so that the electric field generated by the implanted electrons concentrates the electron beam used to expose the resist in the interior of the elementary patterns of said second pattern.

CD

S

## FIG.1A

FEI

MPI                    MPI

CD

S

## FIG.1B

MPI

CD                              EP

+++++        +++++
++++         ++++            T

S

## FIG.1C

FIG.1D

FIG.1E

FIG.1F

FIG.2

FIG.3

**RÉFÉRENCES CITÉES DANS LA DESCRIPTION**

**Documents brevets cités dans la description**

- FR 2994489